(19) Europäisches Patentamt
European Patent Office
Office européen des brevets

(11) Publication number: 0 125 767 A2

(12) EUROPEAN PATENT APPLICATION

(21) Application number: 84301979.5

(22) Date of filing: 23.03.84

(51) Int. Cl.[3]: H 01 L 23/30
H 01 L 23/28

(30) Priority: 06.04.83 GB 8309363

(43) Date of publication of application: 21.11.84 Bulletin 84/47

(84) Designated Contracting States: DE FR GB IT NL SE

(71) Applicant: IMPERIAL CHEMICAL INDUSTRIES PLC
Imperial Chemical House Millbank
London SW1P 3JF(GB)

(72) Inventor: Abbott, Steven John
114 Main Street
Halton Runcorn Cheshire WA7 2PN(GB)

(72) Inventor: Shirley, Ian Malcolm
19 Long Meadow
Weaverham Cheshire(GB)

(74) Representative: Thomas, Ieuan et al,
Imperial Chemical Industries PLC Legal Department: Patents PO Box 6
Welwyn Garden City Herts, AL7 1HD(GB)

(54) **A coated or encapsulated product.**

(57) A coated or encapsulated product is disclosed which comprises a coating or encapsulating layer comprising an arylene homo- or co-polymer, e.g. polyphenylene, on a suitable substrate, e.g. an electronic wafer.

EP 0 125 767 A2

Croydon Printing Company Ltd.

0125767

Pm. 32663/EP

TITLE MODIFIED
see front page

RESISTS

This invention relates to the production of coated or encapsulated products.

Coating or encapsulation of certain products, e.g. metal panels and electronic components is well known. Such coating or encapsulation may be used to protect the product from the environment and/or to act as an insulating dielectric. In the electronics industry, coating or encapsulation of integrated circuits is typically effected with a polyimide.

We have now found that certain substrates may be coated or encapsulated with certain homo- and co-polymers of cyclohexadienes which may then be converted into homo- or co-polymers of arylenes. Such coating or encapsulating layers of arylene polymers often have better thermal stability than the coating or encapsulating layers of other polymers, e.g. polyimides, used hitherto in such applications.

According to a first aspect of the present invention there is provided a coated or encapsulated product which comprises a coating or encapsulating layer which comprises an arylene homo- or co-polymer, on a substrate which does not consist of glass or potassium bromide.

According to a second aspect of the present invention there is provided a process for the preparation of a coated or encapsulated product which comprises a coating or encapsulating layer which is an arylene homo- or co-polymer on a substrate which does not consist of glass or potassium bromide, which process comprises the steps of (A) coating or encapsulating a substrate with a layer of a suitable homo- or co-polymer of a 1,2-disubstituted-cyclohexa-3,5-diene and (B) subjecting the product from step A to a suitable treatment to convert the said homo- or co-polymer into an arylene homo- or copolymer.

In a preferred embodiment of the present invention the substrate is a component of an integrated circuit.

The arylene homo- or co-polymer of which coated or encapsulated products according to the first aspect of the present invention are comprised preferably has a structure represented by the general formula

$$-\left(Ar\right)_n-\left(X\right)_m- \qquad I$$

wherein the residues Ar and X, where X is present, may vary from unit to unit in the polymer chain, Ar represents a divalent aromatic or substituted aromatic group, X is a residue of one or more polymerisable comonomers as hereinafter defined, n and m are whole numbers and the ratio of n:m lies in the range 1:0 to 1:100.

The 1,2-disubstituted-cyclohexa-3,5-diene homo- or co-polymer used in the process according to the second aspect of the present invention preferably has a structure represented by the general formula

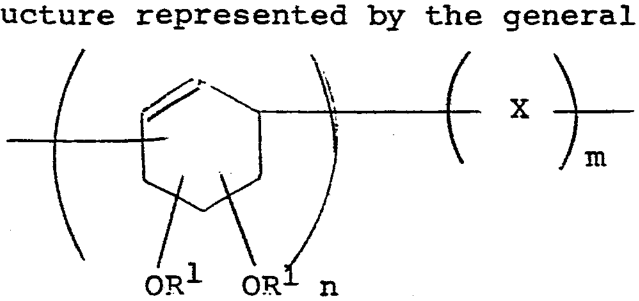

II

wherein the cyclohexenylene ring and the residue X, where X is present, may vary from unit to unit along the polymer chain; each R', which may be the same or different, is hydrogen, hydrocarbyl, e.g. lower alkyl having up to five carbon atoms, aroyl, alkanoyl having up to ten carbon atoms, or preferably $R^2OCO$, where $R^2$ is aryl or an alkyl group having up to ten carbon atoms preferably one or two carbon atoms; X, n and m have the meanings hereinbefore ascribed to them.

By "polymerisable comonomer" we mean a compound which can be reacted under polymerisation conditions with a 1,2-disubstituted-cyclohexa-3,5-diene which has 1,2-substituents as hereinbefore defined to form a copolymer therewith.

Examples of suitable polymerisable comonomers which may be present in copolymers of general formula I or II include interalia vinyl monomers, for example, olefinic hydrocarbons, e.g. styrene, methacrylates, vinyl halides, vinyl esters, acrylonitrile and tetrafluoroethylene; and compounds such as sulphur dioxide.

In polymers of general formula I, Ar is preferably a phenylene ring.

The linkages by which the phenylene rings are bonded in the polymer backbone may be ortho or para to each other, and it is often preferred that both types of linkages are present.

In polymers of general formula II the polymer backbone preferably comprises both cyclic ring

ring

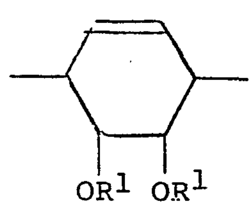

and cyclic

ring

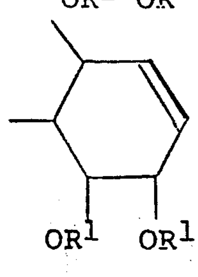

The 1,2-substituents in the poly(1,2-disubstituted-cyclohexa-3,5-diene) which are used in the process of the second aspect of the present invention are conveniently cis to each other since such polymers may be derived from cis-1,2-dihydroxycyclo-hexa-3,5-dienes which may be readily prepared by bio-chemical processes as is more fully described in our European patent application Publication No.76606A. However, we do not exclude the possibility that the aforesaid substituents may be trans to each other, as we have shown in European patent application No.82305028.1 that such systems may be readily converted into polyarylenes.

As additional, non-preferred, examples of the aforesaid 1,2-substituents may be mentioned interalia amide, halide, thioester, urethane and xanthate.

As examples of materials from which suitable substrates of which coated products according to the present invention are comprised may be prepared may be mentioned inter alia metals, for example noble metals, e.g. platinum, transition metals, e.g. copper and nickel, engineering metals, e.g. mild steel and aluminium; or preferably materials used in the electronic industries, for example, silicon,silicon dioxide, gallium arsenide, which may have been subjected to a treatment and/or contain an additive known in the art, e.g. a suitable dopant which renders them semi-conducting, e.g. phosphorus or boron.

For use in the electronics industry, the substrate is typically in the form of a chip, plate or water. The surface of the substrate may be planar or it may have one or more steps therein, for example in the form of a pattern of a printed circuit.

The substrate may be a three-dimensional object, however it is often two-dimensional and typically it is in the form of a thin layer which is supported on a suitable support, e.g. a thin layer of silicon dioxide supported on a silicon plateor a thin layer of copper on glass. Methods of forming thin layers on suitable

In the coating or encapsulating step (A) in the process according to the second aspect of the present invention, the substrate may be coated or encapsulated using conventional coating or encapsulating techniques. Preferably, the coating or encapsulation is effected by a spin process.

In the coating or encapsulating step (A) in the process according to the second aspect of the present invention, the 1,2-disubstituted-cyclohexa-3,5-diene homo- or co-polymer is used as a solution in a suitable solvent. Suitable solvents which may be used include _inter alia_ chlorobenzene, dioxan, chloroform, diglyme, 1,2-dichloroethane, tetrachloroethane. It is often preferred that the solution contains a catalyst, preferably an organic amine, e.g. tri-n-octylamine, as disclosed in our copending European patent application No.83305174.1, the disclosure in which is incorporated herein by way of reference, for catalysing conversion of the said homo- or co-polymer into an arylene homo- or co-polymer.

The 1,2-disubstituted-cyclohexa-3,5-diene homo- or co-polymer used in step (A) in the process according to the second aspect of the present invention may be prepared as described in our copending European patent application No.82305028.1, the disclosure in which is incorporated herein by way of reference.

In the conversion step (B) in the process according to the present invention, the substrate with its coating or encapsulation of a 1,2-disubstituted-cyclohexa-3,5-diene polymer is heated under oxygen-free conditions as described in our copending European patent application Nos.82305028.1 and 83305174.1. Preferably such heat treatment is carried out at between 150°C and 450°C; more preferably the temperature is raised firstly to 300°C over typically 30 to 40 minutes or, for thicker coatings, up to 4 hours and secondly to up to 450°C instantly or during up to about 10 minutes. In order to improve the dimensional stability of the coating or encapsulating layer in products according to the present invention, the temperature used in the heat treatment is often at least that to which the product may be subjected in use.

It will be appreciated that the thickness of the coating or encapsulating layer will depend interalia on the quantity and concentration of the solution used in step (A) and the rate of spinning, where a spin process is used, used in step (A). Typically, thicknesses up to about 10 microns may be obtained. Where greater thicknesses are desired it is preferred that the process according to the second aspect of the present invention is carried out a plurality of times on the substrate.

It will be appreciated that adhesion of the coating or encapsulating layer to the substrate may be improved by using clean components, purified polymers, purified solvents, prebaking and post-baking steps and by the use of adhesion promoters, e.g. silanes, in the process according to the second aspect of the present invention. Typically, the substrate is treated such that the surface thereof is substantially free of foreign particulate material, grease and moisture. Such treatment often includes baking in an oven at about 200°C, say, for up to 1 hour in an inert, e.g. nitrogen, atmosphere.

The coating or encapsulating layer may be used as a so-called passivating layer, by which is meant a barrier to reduce the deleterious effects of water, ionic impurities and ionising radiation on the component. Alternatively, the coating or encapsulating layer may be used as an insulating dielectic between active layers of an integrated circuit.

The invention is illustrated by the following examples.

EXAMPLE 1

A silicon wafer (diameter 50 mm) was cleaned and prebaked at 130°C for 30 minutes under nitrogen. A 20% solution of a poly(bismethyl carbonate of cis-1,2-dihydroxycyclohexa-3,5-diene) in chlorobenzene was spin coated at 4000rpm for one minute. The solvent was removed by heating from 80°C to 150°C over 30 minutes under $N_2$. The coated wafer was then heated in vacumn for one hour at 300°C.

Fourier Transform infra-red spectroscopy of the coated wafer showed substantially complete conversion of the cyclohexadiene polymer into polyphenylene and interference fringes indicated that the thickness of the coating was approximately one micron. Scanning electron microscopy showed that the film was of excellent quality as judged by absence of flaking, pinholing, cracking and by the ability to form a conformal coating over surface features.

The coated wafer was heated to 600°C for two hours in a vacumn and scanning electron microscopy showed no deterioration in the quality of the film.

Examples 2-10

General Procedure

A substrate in the form of a plate or a thin layer supported thereon was baked at 200°C for 30 minutes in a nitrogen atmosphere.

A Polymer of the bis(methylcarbonate) of 1,2-dihydroxy-cyclohexa-3,5-diene (1 part by weight) was dissolved in a suitable solvent, tri-n-octylamine (0.045 parts by weight) was added to the solution and it was filtered through a filter of pore size between 0.2 and 1.0 microns.

A portion of the solution was placed on the substrate surface and the substrate was spun in a conventional spin-coating machine to deposit a coating on the substrate. The solvent was removed from the coating by drying in air at ambient temperature or at 80°C to 150°C in a nitrogen atmosphere.

The coated plate was then heated in a nitrogen atmosphere under conditions (i) placing in an oven at 300°C for a suitable length of time or (ii) placing in an oven and raising the temperature continuously over 1 hour to 410°C, except Example 3.

Completion of the aromatisation reaction was shown by Fourier transform infra-red spectroscopy, in the transmission mode for IR-transparent substrates and by a reflectance method for IR-opaque substrates.

Details of the reaction conditions are given in Table 1.

The coated products according to the present invention prepared in Example 2 were heated for 15 minutes at 0.11 $Nm^{-2}$ in a pressure cooker. Optical microscopy revealed no evidence of detachment of the coatings. Direct pull-off tests using a metal dolly bonded to the coating with "Araldite" (RTM) revealed that the removal stress was between 0.18 and 0.34 $Nm^{-2}$.

Optical and scanning electron microscopy of the coated products according to the present invention prepared in Examples 2, 3 and 4 indicated that the coatings were pin-hole-free, crack-free and conformed to the surface of the substrate.

Samples of the coated products according to the present invention prepared in the Examples were subjected to a low pressure (approximately 0.8 Torr) plasma in the barrel of a "Plasmaprep 100" at 100 watts forward power and 5 watts reflected power, after 10 minutes the thickness of the coating had decreased by between 0.2 and 0.8 microns. This indicates that the coated products may be used in plasma-etching processes in the electronics industry.

Table 1

| Example No | Substrate | Dopant | Surface Contours | Support | Solvent | RPM | Thickness of coating after step A (microns) | Heating Conditions |
|---|---|---|---|---|---|---|---|---|
| 2 | Si | - | Plain | - | Dioxan[d] | 1500 | 4.6 | i(0.5 hours) |
| 3 | Si | B | " | - | " | 3000 | 3.0 | h |
| 4 | Si | P | " | - | " | 2500 | 3.6 | i(3 hours) |
| 5 | $SiO_2$[c] | - | " | Si | " | 2000 | 4.1 | ii |
| 6 | $SiO_2$[c] | P[b] | " | Si | " | 1000 | g | ii |
| 7 | Al[c] | - | " | $SiO_2$/Si | " | 7000 | g | i(6 hours) |
| 8 | $SiO_2$[c] | - | Stepped[a] | Si | 1,2Dichloro -ethane[e] | 2500 | g | ii |
| 9 | $SiO_2$[c] | P[b] | " | Si | Chlorobenzene[f] | 2500 | g | ii |
| 10 | Al[c] | - | " | $SiO_2$/Si | " | 2500 | g | ii |

a: Steps are typically between o.7 and 1.0 microns.
b: Concentration of dopants is typically between 3 and 7%.
c: Thickness is typically between 0.1 and 1.0 microns.
d: 1 Gram of polymer was dissolved in 5 mls solvent.
e: 1 Gram of polymer was dissolved in 3 mls solvent.
f: 1 Gram of polymer was dissolved in 6 mls of solvent.
g: Not determined.
h: Raised to 450°C over 100 minutes.

## CLAIMS

1. A coated or encapsulated product which comprises a coating or encapsulating layer which comprises an arylene homo- or co-polymer on a substrate which does not consist of glass or potassium bromide.

2. A product as claimed in claim 1 wherein the arylene homo- or co-polymer has a structure represented by the formula

$$-\left( Ar \right)_n - \left( X \right)_m -$$

where the residues Ar and X, where X is present, may vary from unit to unit along the polymer chain, Ar represents a divalent aromatic or substituted aromatic group, X is a residue of one or more polymerisable comonomers, n and m are whole numbers and the ratio of n:m lies in the range 1:0 to 1:100.

3. A product as claimed in claim 2 wherein Ar is phenylene.

4. A product as claimed in claim 2 wherein m is 0.

5. A product as claimed in claim 1 wherein the substrate is a component of an integrated circuit.

6. A product as claimed in claim 5 wherein the substrate is in the form of a thin layer.

7. A product as claimed in claim 5 or 6 wherein the substrate is formed from a metal, or a conducting or semi conducting material.

8. A product as claimed in claim 7 wherein the substrate is formed from platinum, copper, nickel, steel, aluminium, silicon, silicon dioxide, or aluminium.

9. A process for the preparation of a coated or encapsulated product as claimed in claim 1 which process comprises the steps of (A) coating or encapsulating a substrate with a layer of a suitable homo- or co-polymer of a 1,2-disubstituted-cyclohexa-3,5-diene and (B) subjecting the product from step A to a suitable treatment to convert the said homo- or co-polymer into an arylene homo- or co-polymer.

10. A process as claimed in claim 9 wherein the suitable homo- or co-polymer of a 1,2 -disubstituted-cyclohexa-3,5-diene has a structure represented by the general formula

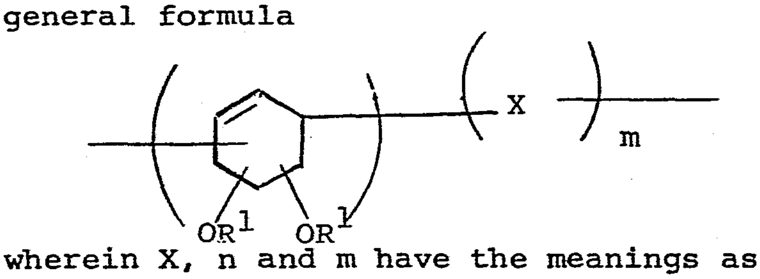

wherein X, n and m have the meanings ascribed to them in claim 2 and $R^1$, each of which may be the same or different, is hydrogen, aroyl, alkanolyl, or $R^2OCO$, where $R^2$ is aroyl or an alkanoyl group having up to ten carbon atoms.

11. A process as claimed in claim 10 wherein m is 0.

12. A process as claimed in claim 9 wherein step A is a spin process.